# DEMANDE DE BREVET EUROPEEN

(11) **EP 2 639 552 A1**
(43) Date de publication de la demande: **18.09.2013**
(21) Numéro de dépôt: 13157498.0
(22) Date de dépôt: 01.03.2013
(51) Int. Cl.: G01C 21/16, F16F 15/08, G01C 19/5769, G01C 19/5783, G01C 19/5628, G01C 19/5663

(54) **Centrale inertielle comprenant un boitier et un ensemble capteur suspendu**

(30) Priorité: 15.03.2012 FR 1200787
(71) Demandeur: Thales, 92200 Neuilly Sur Seine (FR)
(72) Inventeur: Chevalier, Jean-René, 86530 CENON SUR VIENNE (FR); Lesage, Thomas, 37250 VEIGNE (FR)
(74) Mandataire: Brunelli, Gérald

(57) **Abrégé**

L'invention porte sur une centrale inertielle comprenant un boîtier et un ensemble capteur inertiel suspendu (ECIS) muni de capteurs de mouvements liés rigidement entre-eux, caractérisé en ce qu'elle comprend :
- un premier ensemble de suspension interne audit ensemble capteur, entre un support mécanique rigide sur lequel sont montés lesdits capteurs et une pièce mécanique intermédiaire, à faible débattement comprenant un premier nombre N₁, au moins égal à quatre, de plots de suspension montés fixement sur ledit ensemble capteur suspendu ; et
- un deuxième ensemble de suspension externe audit ensemble capteur, entre ladite pièce intermédiaire, faisant partie de l'ensemble suspendu et ledit boîtier, ledit deuxième ensemble de suspension externe étant à fort débattement, comprenant un deuxième nombre N₂, au moins égal à quatre, de plots de suspension liés rigidement audit boîtier, et ne faisant pas partie de l'ensemble capteur suspendu.

## Description

La présente invention porte sur une centrale inertielle munie d'un boîtier et d'un ensemble capteur suspendu, ou coeur suspendu, muni de capteurs de mouvements liés rigidement entre-eux.

Une centrale inertielle ou référence inertielle se comprend d'une façon très générale :
- un boîtier intégrant des cartes électroniques sur lesquelles se trouvent embarquées des capacités de calcul et de dialogue ; et
- un ensemble de capteurs de mouvement tels des capteurs accélérométriques et/ou magnétométriques et/ou gyrométriques liés rigidement entre eux généralement nommés coeur inertiel ou ensemble capteur inertiel.

Afin d'éviter de perturber les mesures de précision effectuées par ce coeur inertiel, il est généralement isolé mécaniquement du boîtier par une suspension se comportant sous environnement mécanique comme un filtre passe-bas pour les vibrations et/ou chocs.

Pour des raisons évidentes de limitation de coûts, il serait intéressant de développer un ensemble capteur inertiel ou coeur inertiel générique, pouvant répondre à la fois à des besoins civils et militaires.

Or, l'aéronautique civile requiert de faibles encombrements et une faible masse, compatibles par ailleurs avec les contraintes mécaniques appliquées au matériel. Dans ce cadre, il est nécessaire de développer un coeur inertiel compact, avec une solution de suspension de coût limité, d'encombrement limité, et donc de faible débattement.

Une telle suspension n'est pas compatible avec des applications aéronautiques militaires, pour lesquelles des débattements plus importants sont généralement nécessaires.

En outre, le problème de la réutilisation de coeurs inertiels n'est pas résolu et il est nécessaire de réadapter le coeur inertiel suspendu pour chaque nouveau programme. Généralement, la mécanique supportant les amortisseurs doit être retouchée, ce qui implique de recalculer tout ou partie l'équilibrage du coeur inertiel suspendu, cette opération pouvant s'avérer relativement coûteuse.

De plus, l'introduction de capteurs de type microsystèmes électromécaniques, ou MEMS pour abréviation de "Microelectromechanical systems" en langue anglaise, de haute performance sur un ensemble capteur inertiel suspendu est peu usitée et nécessite un filtrage différent de celui des centrales inertielles connues.

En outre, les centrales inertielles connues présentent des défauts de symétrie. En effet, il est nécessaire, afin d'éviter les erreurs de dérive gyrométrique liées aux mouvements coniques et de biais accélérométrique liées aux mouvements de godille ("coning" et "sculling" dans la littérature en langue anglo-saxonne, et termes assez largement repris dans les publications en langue française), de faire coïncider au mieux le centre d'inertie et le centre élastique des coeurs inertiels suspendus.

Un but de l'invention est de pallier les problèmes cités précédemment.

En particulier, un but de l'invention est de proposer un coeur inertiel adapté pour des environnements différents, tels que civils et militaires.

Il est proposé, selon un aspect de l'invention, une centrale inertielle comprenant un boîtier et un ensemble capteur inertiel suspendu muni de capteurs de mouvements liés rigidement entre-eux, **caractérisé en ce qu'**elle comprend :
- un premier ensemble de suspension interne audit ensemble capteur, entre un support mécanique rigide sur lequel sont montés lesdits capteurs et un ensemble mécanique intermédiaire, à faible débattement comprenant un premier nombre N₁, au moins égal à quatre, de plots de suspension montés fixement sur ledit ensemble capteur suspendu ; et
- un deuxième ensemble de suspension externe audit ensemble capteur, entre ledit ensemble mécanique intermédiaire, faisant partie de l'ensemble suspendu et ledit boîtier, ledit deuxième ensemble de suspension externe étant à fort débattement, comprenant un deuxième nombre N₂, au moins égal à quatre, de plots de suspension liés rigidement audit boîtier, et ne faisant pas partie de l'ensemble capteur suspendu.

Une telle centrale inertielle est adaptée pour fonctionner tant en environnement civil qu'en environnement militaire, à faible surcoût de réalisation, mais évitant d'importants coûts d'adaptation.

Dans un mode de réalisation, le premier nombre N₁ est égal à quatre, et le deuxième nombre N₂ est égal à quatre.

Un tel mode de réalisation est optimal en terme de résultats par rapport à la complexité et au coût de réalisation.

Selon un mode de réalisation, les quatre plots de suspension du premier ensemble de suspension interne sont les sommets d'un premier berlingot, et les quatre plots de suspension du deuxième ensemble de suspension externe sont les sommets d'un deuxième berlingot dont les arrêtes reliant deux sommets distincts sont symétriques aux sommets respectifs du premier berlingot.

Une telle géométrie possède une symétrie permettant d'éviter les erreurs de dérive gyrométrique liées aux mouvements coniques et de biais accélérométrique liées aux mouvements de godille.

Dans un mode de réalisation, ledit ensemble mécanique intermédiaire comprend deux éléments intermédiaires, tels des croisillons ou équivalents, adaptés pour lier ensemble rigidement deux plots de suspension du premier ensemble de suspension interne et deux plots de suspension du deuxième ensemble de suspension externe.

Ainsi, la partie de la suspension externe au coeur ou ensemble capteur peut être ajoutée très facilement, sans retoucher ou démonter les plots internes du coeur suspendu.

Selon un mode de réalisation, les deux éléments intermédiaires comprennent respectivement un croisillon, par exemple identiques, ou , en d'autres termes, une pièce de renfort en forme de croix.

Une telle réalisation est aisée et de coût réduit.

Par exemple, les deux éléments intermédiaires sont adaptés pour recevoir des capteurs additionnels.

Ainsi, les pièces mécaniques ajoutées entre les suspensions peuvent supporter des capteurs de mesure (accélération, températures, ...) permettant le cas échéant, d'activer ou de participer au traitement des informations délivrées par le coeur inertiel.

Dans un mode de réalisation, lesdits plots de suspension sont à symétrie de révolution.

Ainsi, on peut distinguer, pour chaque plot des raideurs (linéaires et angulaires) axiales et radiales qui peuvent, par la suite, être associées ou compensées selon l'orientation des plots.

Selon un mode de réalisation, les plots sont disposés de sorte que les axes de révolution des quatre plots du premier ensemble de suspension interne sont parallèles entre-eux dans une première direction, les axes de révolution des quatre plots du deuxième ensemble de suspension externe sont parallèles entre-eux dans une deuxième direction, lesdites première et deuxième directions étant perpendiculaires.

Ainsi, il est possible de faire travailler les plots dans deux directions selon leur mode radial, et dans la troisième direction selon le mode axial.

En variante, selon un autre mode de réalisation, les plots sont disposés de sorte que les axes de révolution des plots passent par le centre d'inertie de l'ensemble capteur inertiel suspendu.

Ainsi, des optimisations peuvent être faites par rapport aux modes obtenus.

Dans un autre mode de réalisation, les axes de révolution de deux plots distincts forment un angle compris entre 0 et 90 degrés.

Selon un mode de réalisation, lesdits capteurs de mouvements comprennent au moins un microsystèmes électromécaniques.

Ainsi, le deuxième ensemble de suspension externe est particulièrement bien adapté pour garantir un filtrage suffisant pour des MEMS.

L'invention sera mieux comprise à l'étude de quelques modes de réalisation décrits à titre d'exemples nullement limitatifs et illustrés par les dessins annexés sur lesquels :
- la figure 1 illustre schématiquement une centrale inertielle munie de deux ensemble de suspension, selon un aspect de l'invention ;
- la figure 2 illustre schématiquement une centrale inertielle munie de deux ensemble de suspension, selon un autre aspect de l'invention ;
- les figures 3a et 3b illustrent un exemple de réalisation d'éléments intermédiaires adaptés pour lier ensemble rigidement deux plots de suspension du premier ensemble de suspension interne et deux plots de suspension du deuxième ensemble de suspension externe, selon un aspect de l'invention.

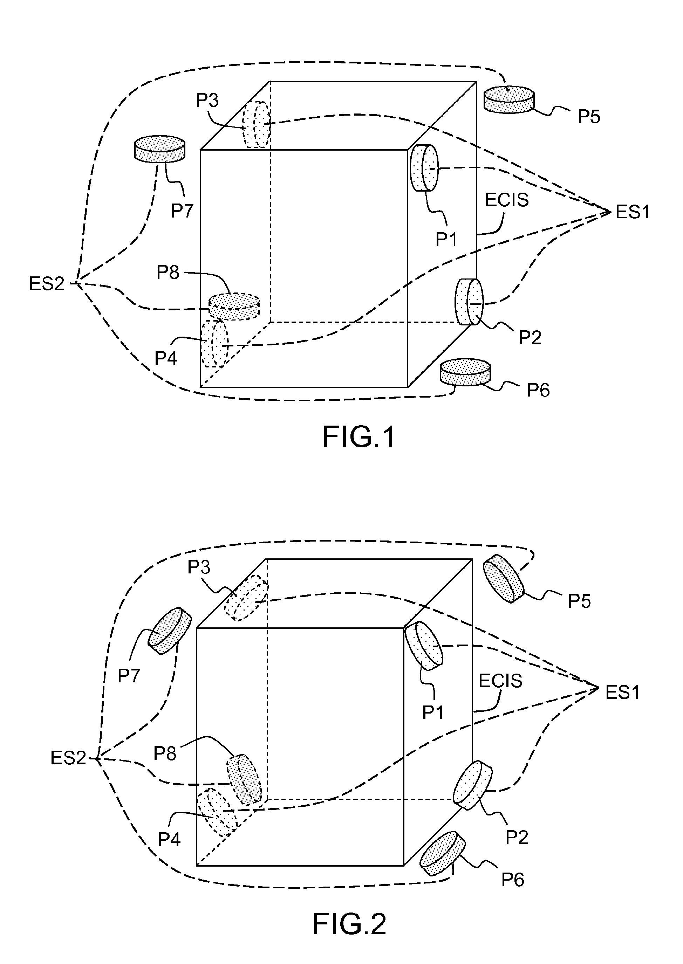

Tel qu'illustré sur la figure 1, un ensemble capteur inertiel suspendu ECIS ou coeur inertiel d'une centrale inertielle comprend un premier ensemble de suspension ES1 interne à l'ensemble capteur, entre le support mécanique rigide sur lequel sont montés ces capteurs et un ensemble mécanique intermédiaire, à faible débattement comprenant un premier nombre N₁ au moins égal à quatre, de plots de suspension montés fixement sur ledit ensemble capteur suspendu, et un deuxième ensemble de suspension externe ES2 externe à l'ensemble capteur, entre l'ensemble mécanique intermédiaire, faisant partie de l'ensemble suspendu et le boîtier, à fort débattement comprenant un deuxième nombre N₂, au moins égal à quatre, de plots de suspension liés rigidement audit boîtier.

Les notions de fort débattement et faible débattement sont relatives, et typiquement de l'ordre du mm pour la suspension interne à l'ensemble capteur et de la dizaine de mm pour la suspension externe.

Sur les figures 1 et 2, le support mécanique rigide sur lequel sont montés les capteurs et l'ensemble mécanique intermédiaire ne sont pas représentés.

En l'espèce, sur l'exemple de la figure 1 sont représentées un premier ensemble de suspension interne ES1 comprenant quatre plots de suspension P1, P2, P3 et P4, i.e. N₁=4, et un deuxième ensemble de suspension externe ES2 comprenant quatre plots de suspension P5, P6, P7 et P8, i.e. N₂=4.

Sur l'exemple de la figure 1, les quatre plots de suspension P1, P2, P3 et P4 du premier ensemble de suspension interne ES1 sont les sommets d'un premier berlingot, et les quatre plots de suspension P5, P6, P7 et P8 du deuxième ensemble de suspension externe ES2 sont les sommets d'un deuxième berlingot dont les arrêtes reliant deux sommets distincts sont symétriques aux sommets respectifs du premier berlingot.

Une suspension de type "berlingot" peut être définie par la position des quatre plots de suspension les uns par rapport aux autres. Si on prend pour origine le centre élastique de l'ensemble de quatre plots, et si on note dx, dy et dz trois distances selon trois axes orthogonaux directs dont l'intersection se situe au centre élastique de l'ensemble suspendu, la position des quatre plots est donnée par : (dx, -dy, -dz) ; (-dx, -dy, dz) ; (-dx, dy, -dz) ; et (dx, dy, dz).

Sur cet exemple, l'ensemble des plots P1, P2, P3, P4, P5, P6, P7 et P8 des deux ensemble de suspension ES1 et ES2 sont des plots de suspension à symétrie de révolution, disposés de sorte que les axes de révolution des quatre plots P1, P2, P3, et P4 du premier ensemble de suspension interne ES1 sont parallèles entre-eux dans une première direction, les axes de révolution des quatre plots P5, P6, P7 et P8 du deuxième ensemble de suspension externe ES2 sont parallèles entre-eux dans une deuxième direction, et lesdites première et deuxième directions sont perpendiculaires.

Ce mode de réalisation permet de compenser les caractéristiques axiales et radiales des suspensions interne et externe au coeur.

En variante, comme illustré sur la figure 2, les plots sont disposés de sorte que les axes de révolution des plots passent tous par le centre d'inertie de l'ensemble capteur inertiel suspendu ECIS.

Ce mode de réalisation permet de minimiser les erreurs de dérive gyrométrique liées aux mouvements coniques et les erreurs de biais accélérométrique liées aux mouvements de godille.

De manière plus générale, les axes de révolution de deux plots distincts peuvent former un angle compris entre 0 et 90 degrés.

Ces exemples de réalisations dans lesquels chaque ensemble de suspension interne et externe ES1, ES2 comprend quatre plots de suspension présente un intérêt particulier de rapport coût/résultat.

Une centrale inertielle selon un aspect de l'invention peut comprendre deux éléments intermédiaires adaptés pour lier ensemble rigidement deux plots de suspension du premier ensemble de suspension interne et deux plots de suspension du deuxième ensemble de suspension externe.

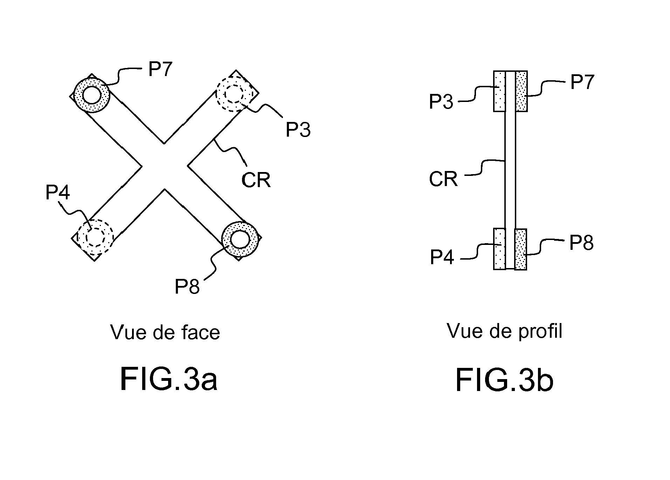

Les figures 3a et 3b représentent schématiquement un exemple de réalisation de tels éléments intermédiaires, en l'espèce réalisé sous forme de croisillons CR.

Les croisillons CR sont un exemple de réalisation de l'ensemble mécanique intermédiaire.

La figure 3a représente une vue de face et la figure 3b une vue de côté d'un tel croisillon CR liant rigidement par exemple les plots P3 et P4 du premier ensemble de suspension ES1 et les plots P7 et P8 du deuxième ensemble de suspension ES2.

Les éléments intermédiaires peuvent être identiques et adaptés pour recevoir des capteurs additionnels (accélération, températures, ...) permettant d'activer ou de participer au traitement des informations délivrées par l'ensemble capteur inertiel suspendu ECIS.

L'ensemble capteur inertiel suspendu ECIS peut comprendre au moins un microsystème électromécanique ou MEMS, auquel cas la double suspension selon l'invention est particulièrement bien adaptée pour un filtrage efficace des perturbations extérieures (vibrations, chocs), qui, ainsi, ne perturbent plus le coeur inertiel suspendu ECIS.

## Revendications

1. Centrale inertielle comprenant un boîtier et un ensemble capteur inertiel suspendu (ECIS) muni de capteurs de mouvements liés rigidement entre-eux, **caractérisé en ce qu'**elle comprend :
- un premier ensemble de suspension interne (ES1) audit ensemble capteur, entre un support mécanique rigide sur lequel sont montés lesdits capteurs et un ensemble mécanique intermédiaire, à faible débattement comprenant un premier nombre N₁, au moins égal à quatre, de plots de suspension (P1, P2, P3, P4) montés fixement sur ledit ensemble capteur suspendu (ECIS) ; et
- un deuxième ensemble de suspension externe (ES2) audit ensemble capteur, entre ledit ensemble mécanique intermédiaire, faisant partie de l'ensemble suspendu et ledit boîtier, ledit deuxième ensemble de suspension externe étant à fort débattement, comprenant un deuxième nombre N₂, au moins égal à quatre, de plots de suspension (P5, P6, P7, P8) liés rigidement audit boîtier, et ne faisant pas partie de l'ensemble capteur suspendu.

2. Centrale inertielle selon la revendication 1, dans laquelle le premier nombre N₁ est égal à quatre, et le deuxième nombre N₂ est égal à quatre.

3. Centrale inertielle selon la revendication 2, dans laquelle les quatre plots de suspension (P1, P2, P3, P4) du premier ensemble de suspension interne (ES1) sont les sommets d'un premier berlingot, et les quatre plots de suspension (P5, P6, P7, P8) du deuxième ensemble de suspension externe (ES2) sont les sommets d'un deuxième berlingot dont les arrêtes reliant deux sommets distincts sont symétriques aux sommets respectifs du premier berlingot.

4. Centrale inertielle selon la revendication 3, dans lequel ledit ensemble mécanique intermédiaire comprend deux éléments intermédiaires adaptés pour lier ensemble rigidement deux plots de suspension (P3, P4) du premier ensemble de suspension interne (ES1) et deux plots de suspension (P7, P8) du deuxième ensemble de suspension externe (ES2).

5. Centrale inertielle selon la revendication 4, dans laquelle les deux éléments intermédiaires comprennent respectivement un croisillon (CR).

6. Centrale inertielle selon la revendication 4 ou 5, dans laquelle les deux éléments intermédiaires sont adaptés pour recevoir des capteurs additionnels.

7. Centrale inertielle selon l'une des revendications précédentes, dans laquelle lesdits plots de suspension (P1, P2, P3, P4, P5, P6, P7, P8) sont à symétrie de révolution.

8. Centrale inertielle selon la revendication 7, dans laquelle les plots sont disposés de sorte que les axes de révolution des quatre plots (P1, P2, P3, P4) du premier ensemble de suspension interne (ES1) sont parallèles entre-eux dans une première direction, les axes de révolution des quatre plots (P5, P6, P7, P8) du deuxième ensemble de suspension externe (ES2) sont parallèles entre-eux dans une deuxième direction, lesdites première et deuxième directions étant perpendiculaires.

9. Centrale inertielle selon la revendication 7, dans laquelle les plots de suspension (P1, P2, P3, P4, P5, P6, P7, P8) sont disposés de sorte que les axes de révolution des plots (P1, P2, P3, P4, P5, P6, P7, P8) passent par le centre d'inertie de l'ensemble capteur inertiel suspendu (ECIS).

10. Centrale inertielle selon la revendication 7, dans laquelle les axes de révolution de deux plots distincts forment un angle compris entre 0 et 90 degrés.

11. Centrale inertielle selon l'une des revendications précédentes, dans laquelle lesdits capteurs de mouvements comprennent au moins un microsystème électromécanique (MEMS).
